# EUROPEAN PATENT SPECIFICATION

(11) **EP 0 367 630 B1**
(45) Date of publication and mention of the grant of the patent: **13.03.1996**
(21) Application number: 89311436.3
(22) Date of filing: 02.11.1989
(51) Int. Cl.: H01L 23/44

(54) **Package for electronic devices operating at different respective temperatures**
Packung für elektronische Anordnungen zum Betrieb bei verschiedenen jeweiligen Temperaturen
Empaquetage pour dispositifs électroniques fonctionnant à températures respectives différentes

(30) Priority: 02.11.1988 JP 276023/88
(43) Date of publication of application: 09.05.1990
(73) Proprietor: FUJITSU LIMITED, Kawasaki-shi, Kanagawa 211 (JP); SHINKO ELECTRIC INDUSTRIES CO. LTD., Nagano-shi, Nagano 380 (JP)
(72) Inventor: Kotani, Seigo, Zama-shi Kanagawa, 288 (JP); Sakai, Hiroyuki, Nagano-shi Nagano, 381 (JP); Takenouchi, Toshikazu, Nagano-shi Nakano, 383 (JP); Miyagawa, Fumio, Nagano-shi Nagano, 388 (JP)
(74) Representative: Fane, Christopher Robin King

(56) References cited:
- EP-A- 0 213 421
- EP-A- 0 228 212
- US-A- 4 245 273
- US-A- 4 734 820
- IBM TECHNICAL DISCLOSURE BULLETIN, vol. 18, no. 4, September 1975, pages 1226-1229, New York, US; V.L. RIEDEOUT : "Close-cycle liquid nitrogen refrigeration system for low-temperature computer operation"

## Description

The present invention relates to the use of electronic devices operating at different respective temperatures.

Recently, a superconducting integrated circuit for a high-speed computer, incorporating superconducting devices such as Josephson junction devices using Nb, has been developed. The Josephson effect is very important in the application of superconductors to the field of electronics. A SQUID (superconducting quantum interference device) for high-sensitivity magnetic field detection, as well as the above-mentioned superconducting integrated circuit, employs the Josephson effect. Currents that flow across a junction of a superconductor/insulator/superconductor structure are classified into Josephson currents that flow without voltage drop, and currents that flow with a finite voltage Vg corresponding to the band gap of the superconductor. The Josephson junction device can be used as a device for logical operation by representing a binary digit "0" by 0 volt, and a binary digit "1" by the finite voltage Vg. Magnetic flux φ arrested by a superconducting loop including the junction can be expressed as φ = nφₒ, where n is an integer and φₒ is a quantum of flux. The Josephson junction device can be used as a digital storage device py representing binary digits "0" and "1" respectively by a state where n = -1 and a state where n = 1.

A logic circuit employing superconducting devices, such as Josephson junction devices, is capable of high speed operation at low power consumption, and hence a high-speed processor can easily be realized by the employment of such a logic circuit. In order to make the most of the advantages of the high-speed processor, it is desirable that high-speed signal exchange between such a high-speed processor and electronic devices, such as LSIs, disposed outside a low-temperature atmosphere be possible. In this respect, the arrangement of a package encapsulating superconducting devices is very important for high-speed signal transmission.

Generally, liquid helium (He) is used as a cryogen for cooling the superconducting device for operation. It has been proposed previously to connect the superconducting device, immersed in liquid He contained in a Dewar vessel, electrically to other semiconductor devices, operating at room temperature, by means of a coaxial cable.

For such an arrangement of superconducting devices and semiconductor devices, the length of the coaxial cable required is at least about 1m, and hence the estimated propagation delay is of the order of 10 ns. As a result of this large propagation delay, it is impossible to drive the superconducting devices, as they operate at a high speed of, for example, 1 ns or less.

US-A-4,734,820 discloses a package for electronic devices, comprising: heat insulating vacuum vessel means capable of maintaining the interior thereof at a desired temperature lower than the ambient temperature outside said heat insulating vacuum vessel means; a first substrate provided with a circuit pattern and having mounted thereon a first electronic device suitable for operation at the said desired temperature, said first substrate being disposed within the heat insulating vacuum vessel means; a second substrate provided with a circuit pattern and having mounted thereon a second electronic device suitable for operation at said ambient temperature, said second substrate being disposed outside the said heat insulating vacuum vessel means; and connecting means which pass through a wall of the said heat insulating vacuum vessel means and electrically connect the circuit pattern of the first substrate to that of the second substrate.

The apparatus disclosed in US-A-4,734,820 is intended to allow the first substrate to be removed easily from the package and to this end the first substrate is provided on one of its main faces with a plurality of electrically-conductive pins whose free ends sit in respective cups containing mercury, which is solid when the interior of the vacuum vessel is maintained at cryogenic temperatures, but liquid at room temperature. The cups are embedded in electrically-conductive and thermally-insulative material which fills respective openings in the wall of the vacuum vessel, which material is in turn electrically connected to the second substrate, mounted in a plane which is parallel to that containing the first substrate. However, the nature and quantity of the connections between the substrates are such that signal propagation delay and heat transfer are unsatisfactory.

EP-A-0213421 discloses an assembly comprising a single substrate disposed within a vacuum vessel on which an electronic device is mounted, the periphery of the substrate extending through openings in respective side walls of the vacuum vessel. Heat transfer along the substrate from its periphery at ambient temperature to the interior of the vessel is therefore considerable.

Accordingly, it is desirable to provide a package for electronic devices in which signal propagation delay can be avoided.

It is also desirable to provide a package for electronic devices in which heat transfer between the electronic devices can be reduced.

According to the present invention, there is provided a package for electronic devices, comprising: heat insulating vacuum vessel means capable of maintaining the interior thereof at a desired temperature lower than the ambient temperature outside said heat insulating vacuum vessel means; a first substrate provided with a circuit pattern and having mounted thereon a first electronic device suitable for operation at the said desired temperature, said first substrate being disposed within the heat insulating vacuum vessel means; a second substrate provided with a circuit pattern and having mounted thereon a second electronic device suitable for operation at said ambient temperature, said second substrate being disposed outside the said heat insulating vacuum vessel means; and connecting means which pass through a wall of the said heat insulating vacuum vessel means and electrically connect the circuit pattern of the first substrate to that of the second substrate; characterised in that said first and second substrates are attached to said heat insulating vacuum vessel means so as to have respective main faces which are substantially co-planar, such that the separation between mutually-adjacent edges of the said first and second substrates is minimized, and said connecting means comprise a film cable formed, in such a way as to suppress heat transfer therealong, by alternately laminating a plurality of electrically-insulating films and a plurality of electrically-conductive films.

The use of the film cable as the connecting means suppresses the influx of heat from the outside to the inside of the heat insulating vacuum vessel means, so that cooling efficiency in cooling the interior of the heat insulating vacuum vessel means is improved.

When in an embodiment of the present invention the first electronic devices are superconducting devices, the heat insulating vacuum vessel means is preferably combined with a cryogenic cooling means for cooling the interior of the heat insulating vacuum vessel means to the operating temperature of the superconducting devices. The heat insulating vacuum vessel means preferably comprises an upper heat insulating vacuum vessel, and a lower heat insulating vacuum vessel separate from the upper heat insulating vacuum vessel. The film cable is attached adhesively to the lower end of the upper heat insulating vacuum vessel and to the upper end of the lower heat insulating vacuum vessel. In a modification, the heat insulating vacuum vessel means may advantageously comprise a heat insulating vacuum vessel provided with a slit in the middle portion thereof, and a heat insulating vacuum lid adhesively attached to the heat insulating vacuum vessel, and the film cable may be provided in the slit and fixed adhesively to the heat insulating vacuum vessel.

Furthermore, desirably, the first and second substrates are multilayer ceramic substrates each formed by alternately laminating a plurality of circuit patterns for signal transmission, and a plurality of ground patterns.

Reference will now be made, by way of example, to the accompanying drawings, in which: -
Figure 1 shows a longitudinal view, partly in cross-section, of apparatus embodying the present invention;
Figure 2 shows a schematic plan view of the apparatus of Fig.1, in which an upper portion of the apparatus has been removed;
Figure 3 shows a schematic sectional view of part of the apparatus shown in Fig.1;
Figure 4 shows a schematic sectional view of another part of the apparatus shown in Fig.1;
Figure 5 shows an enlarged sectional view of a further part of the apparatus of Fig.1;
Figure 6 shows a schematic exploded sectional view of a connection arrangement for use in apparatus embodying the present invention;
Figure 7 shows a top plan view of the arrangement shown in Fig.6;
Figure 8 shows a longitudinal view, partly in cross-section, of further apparatus embodying the present invention; and
Figure 9 shows an enlarged sectional view of part of the apparatus shown in Fig.8.

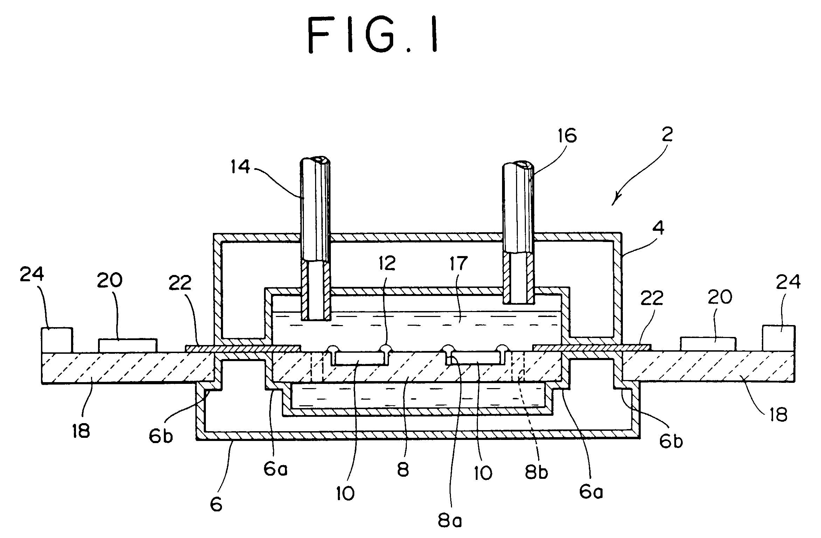

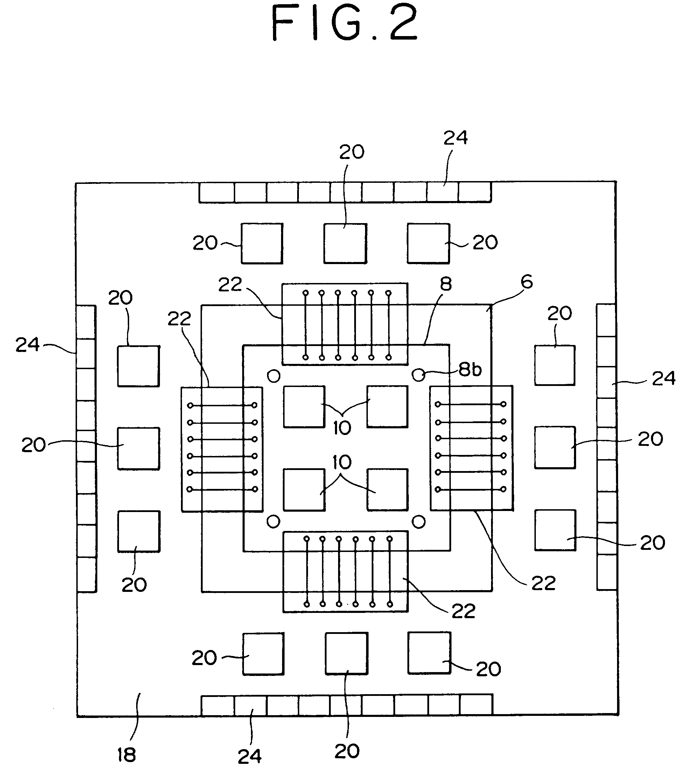

As shown in Figs.1 and 2, electronic apparatus embodying the present invention includes thermal isolation means comprising a heat insulating vacuum vessel 2, which, as illustrated, has the structure of a Dewar vessel. The heat insulating vacuum vessel 2 is separated into an upper heat insulating vacuum portion 4 and a lower heat insulating vacuum portion 6. The upper and lower heat insulating vacuum portions 4 and 6 are formed, for example, of a FRP (fiber reinforced plastic) or an aluminium alloy. The lower heat insulating vacuum portion 6 is provided with an inner step formation 6a and an outer step formation 6b for use in supporting substrates, as will now be described. A multilayer ceramic substrate 8, provided with circuit patterns, is seated on the inner step formation 6a. The multilayer ceramic substrate 8 is provided with four recesses 8a for receiving therein first electronic devices, constituted in this example by superconducting devices 10 such as Josephson devices, and four through holes 8b to allow a cryogen to flow from an upper cavity formed above the substrate 8 to a lower cavity formed under the substrate 8, the upper and lower cavities forming a working chamber. The superconducting devices 10, such as Josephson devices, are placed respectively in the recesses 8a and are bonded to the substrate 8 with silicone grease. The superconducting devices 10 are placed in the recesses 8a with the upper surfaces thereof flush with the upper surface of the multilayer ceramic substrate 8. The superconducting devices 10 are connected electrically to the circuit patterns of the multilayer ceramic substrate 8 by bonding wires 12 formed of an aluminum alloy. Since the upper surface of the superconducting devices 10 and the upper surface of the ceramic substrate 8 are flush with each other, the bonding wires 12 can be as short in length as 0.2mm to 0.4mm, which is advantageous for high-speed signal transmission.

The upper heat insulating vacuum portion 4 is provided with a cryogen supply tube 14 and a cryogen discharge tube 16. This embodiment employs liquid helium as a cryogen. Helium gas liquefies at a temperature of about 4.2 K. Liquid helium 17 supplied through the cryogen supply tube 14 flows through the through holes 8b formed in the ceramic substrate 8 into the lower cavity under the ceramic substrate 8. Thus, the ceramic substrate 8 and the superconducting devices 10 are immersed in the liquid helium 17.

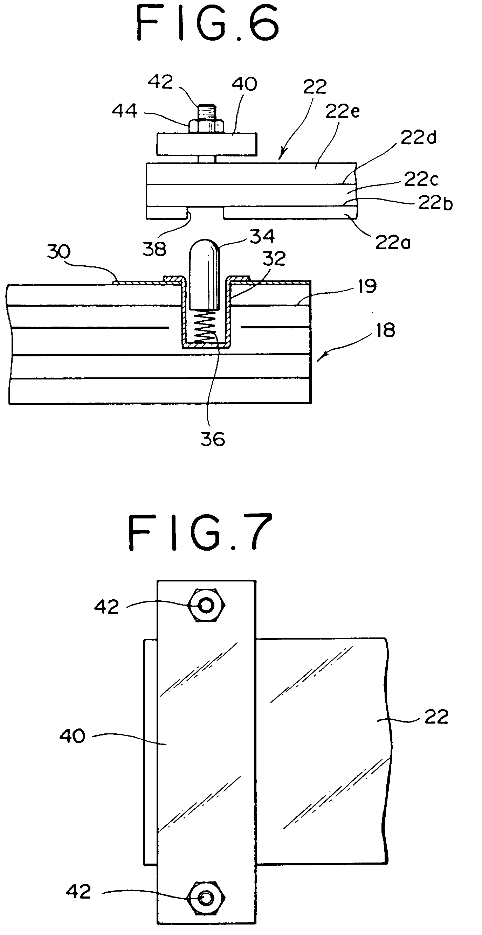

A multilayer ceramic substrate 18 for supporting semiconductor devices which operate at a different temperature, in this case at room temperature, is seated on the outer step formation 6b of the lower heat insulating vacuum portion 6. The multilayer ceramic substrate 18 is provided with circuit patterns, and second electronic devices, in this case semiconductor devices 20 of a surface mounting type, such as flat packages and chip carriers, are mounted on the multilayer ceramic substrate 18. The circuit patterns of the multilayer ceramic substrate 8, and those of the multilayer ceramic substrate 18, are interconnected by film cables (connecting means) 22, as shown in Fig.5, each formed by laminating a plurality of insulating films and a plurality of conductive films. A plurality of coaxial connectors 24 are mounted detachably on the multilayer ceramic substrate 18.

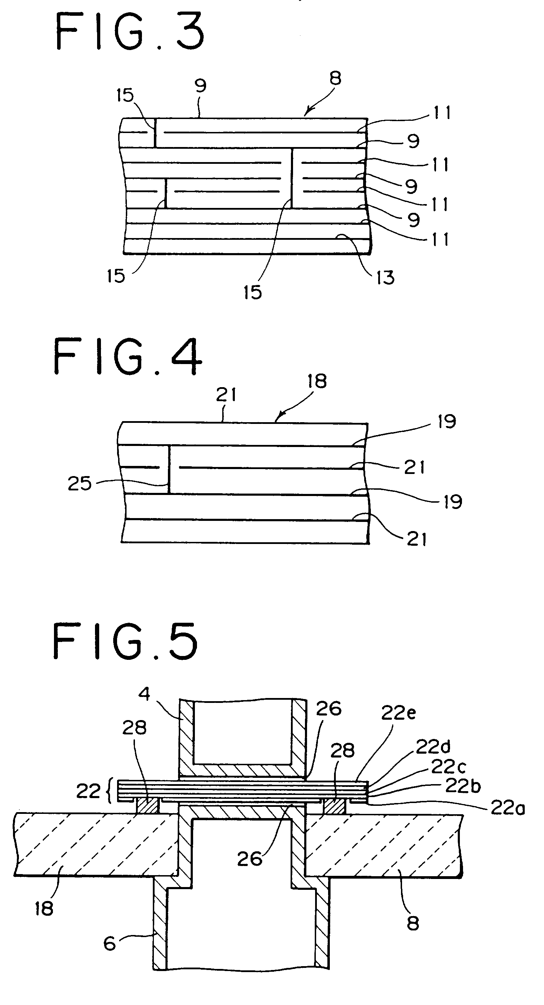

Figs.3 and 4 show respective sectional views of the multilayer ceramic substrates 8 and 18. Referring to Fig.3, the multilayer ceramic substrate 8 for mounting the superconducting devices is of a nine-layer structure formed by alternately laminating a plurality of signal transmitting circuit patterns 9 and a plurality of ground patterns 11, and attaching a single resistance pattern 13 for terminal matching to the bottom ground pattern 11. The patterns are isolated from each other by layers of ceramic. The respective layers of signal patterns 9, ground patterns 11 and the resistance pattern 13 are combined integrally to form the multilayer ceramic substrate 8 by burning. The signal patterns 9 are interconnected properly through via holes 15. Referring to Fig 4, the multilayer ceramic substrate 18 for mounting the semiconductor devices is of a five-layer structure formed by alternately laminating two signal patterns 19 and three ground patterns 21. The signal patterns 19 are interconnected properly through via holes 25. The patterns are isolated from each other by layers of ceramic. The respective layers of signal patterns 19 and ground patterns 21 are combined integrally to form the multilayer ceramic substrate 18 by burning. The characteristic impedances respectively between the signal patterns 9 and the ground patterns 11 of the multilayer ceramic substrate 8, and between the signal patterns 19 and the ground patterns 21 of the multilayer ceramic are 50 Ω.

Referring to Fig.5, the film cable 22 is formed by alternately laminating polyimide films and conductive films formed of copper. That is, the film cable 22 is formed by laminating, from bottom to top, a polyimide film 22a, a signal pattern 22b, a polyimide film 22c, a ground pattern 22d, and a polyimide film 22e. The adjacent polyimide films and the conductive patterns are joined together by an adhesive, such as an epoxy resin.

Thus, essentially the film cable 22 consists of polyimide films and copperfoils. The signal pattern 22b can be formed in a structure advantageous for high-speed signal propagation, such as a strip line structure or a coplanar structure, by etching a copper foil. For example, when the signal pattern 22b is 35 µm thick and 150µm wide, and the polyimide film 22c between the signal pattern 22b and the ground pattern 22d is 25 µm , a characteristic impedance of 50 Ω is realized.

The film cable 22 extends between the upper heat insulating vacuum portion 4 and the lower heat insulating portion 6 and is attached adhesively to those portions 4,6 by an adhesive 26, such as an epoxy resin. The signal patterns 9 and 19 of the ceramic substrates 8 and 18 are connected to the signal pattern 22b of the film cable 22 by solder portions 28. The ground patterns 11 and 21 of the ceramic substrates 8 and 18 are connected to the ground pattern 22d of the film cable 22 by solder at different positions. With a view to suppressing the influx of heat, it is preferable that the copper foil forming the ground pattern 22d has the least possible thickness, for example a thickness of the order of 10 µm . When such a condition is met, the overall thickness of the film cable 22 is of the order of 0.1mm, so that the quantity of heat that flows from the ceramic substrate 18 through the film cable 22 to the ceramic substrate 8 can be kept to a very small value.

An alternative way of connecting the signal pattern of the film cable 22 to the signal patterns of the ceramic substrate 18 will now be explained with reference to Figs. 6 and 7. An insulating film 30 is formed over the top ground pattern 21 to be connected to the external conductor of the coaxial connector 24 of the ceramic substrate 18, and then a plurality of contact holes for receiving contact pins 34 are formed in the ceramic substrate 18. After forming a conductive film over the surface of the insulating film 30 by metallizing, caps 32 are inserted respectively in the contact holes and are soldered to the conductive film, and a contact pin 34 is put in each cap 32 with a coil spring 36 placed between the contact pin 34 and the bottom of the cap 32 so as to bias the contact pin 34 outward. Thus, each contact pin 34 is connected through the coil spring 36 and the cap 32 to the signal pattern 19 of the ceramic substrate 18.

Through holes 38 are formed in the polyimide film 22a of the film cable 22 at positions respectively corresponding to the contact pins 34 to expose portions of the signal pattern 22b. The film cable 22 is pressed against the ceramic substrate 18 by means of a holding plate 40 employing stud bolts 42, fixed to the ceramic substrate 18, and nuts 44, so as to connect the signal pattern 22b of the film cable 22 to the signal patterns 19 of the ceramic substrate 18, through the contact pins 34, the coil springs 36 and the caps 32.

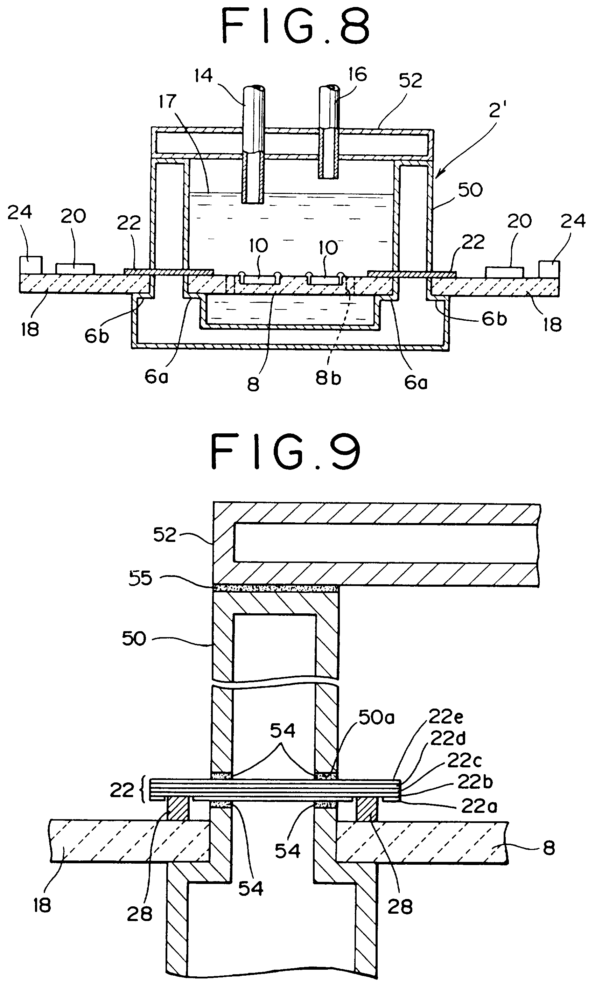

Further electronic apparatus embodying the present invention will be described hereinafter with reference to Figs.8 and 9, in which parts like or corresponding to those of the apparatus described with reference to Figs. 1 to 7 are denoted by the same reference numerals and the description thereof will be omitted to avoid duplication.

The electronic apparatus shown in Figs. 8 and 9 differs from that of Figs.1 and 7 in that a heat insulating vacuum vessel 2′, constituting thermal isolation means, comprises a lower heat insulating vacuum portion 50, having a depth greater than that of the lower heat insulating vacuum portion 6 of the Fig.1 apparatus, and a heat insulating vacuum lid 52 attached by adhesive 55 to the lower heat insulating portion 50, and in that the film cables 22 are inserted in the heat insulating vacuum vessel 2′ respectively through slits 50a formed respectively in the side walls of the lower heat insulating vacuum portion 50. The film cables 22 must be fastened firmly and closely to the lower heat insulating vacuum portion 50 in an airtight fashion by filling up gaps between the film cables 22 and the slits 50a with an adhesive 54, such as an epoxy resin, so as to maintain a vacuum within the heat insulating vacuum vessel 2′ and so to prevent a deterioration in the heat insulating function of the lower heat insulating vacuum portion 50.

In the apparatus of Figs. 8 and 9, heat can flow from the outside to the inside of the heat insulating vacuum vessel 2′ only thorough the film cables 22, and hence the capability of the apparatus of Figs.8 and 9 in suppressing the inflow of heat is higher than that of the apparatus of Fig.1. That is, heat flows into the heat insulating vacuum vessel 2 of Fig.1 through the walls of the upper and lower heat insulating vacuum portions 4 and 6 which adjoin the film cables 22, as well as through the film cables 22. Since the heat insulating vacuum vessel 2′ in Figs.8 and 9 has no wall corresponding to those walls, the influx of heat from outside the heat insulating vacuum vessel 2′ is very small. However, owing to the slits 50a, filled with adhesive 54, in the apparatus illustrated in Figs.8 and 9 it is more difficult, as compared with the apparatus of Fig.1, to maintain a vacuum within the lower heat insulating vacuum portion 50. Incidentally, the heat insulating vacuum vessel 2 or 2′ may be evacuated by known evacuating means, and hence the description of the process of evacuating the heat insulating vacuum vessel 2, 2′ will be omitted, from this application.

In the above-described embodiments of the present invention, the electronic devices provided with the heat insulating vacuum vessel are connected only through the thin film cables to those disposed outside the heat insulating vacuum vessel, so that the influx into the vessel of heat generrated in the ceramic substrate having the semiconductor devices mounted thereon can be suppressed. Accordingly, the cryogen is consumed at a low rate, and hence, when the cryogen is liquid helium, even a small liquefier is sufficient for the purpose. Furthermore, since the superconducting devices and the semiconductor devices can be disposed comparatively near to each other, delay in signal propagation is negligible, so that the superconducting devices can be driven at a high speed.

Although the invention has been described with reference to specific embodiments thereof, the present invention is not limited to those specific embodiments in its practical application and many changes and variations are possible therein. For example, the electronic devices mounted on the ceramic substrate provided within the heat insulating vacuum vessel need not necessarily be superconducting devices, but may be HEMTs (high electron mobility transistors) or the like. Still further, when the superconducting devices employ superconducting materials of the Y-Ba-Cu-O system which have recently been developed, liquid nitrogen may be used instead of liquid helium for cooling the superconducting devices.

## Claims

1. A package for electronic devices, comprising: heat insulating vacuum vessel means (2;2') capable of maintaining the interior thereof at a desired temperature lower than the ambient temperature outside said heat insulating vacuum vessel means (2;2'); a first substrate (8) provided with a circuit pattern (9) and having mounted thereon a first electronic device (10) suitable for operation at the said desired temperature, said first substrate (8) being disposed within the heat insulating vacuum vessel means (2;2'); a second substrate (18) provided with a circuit pattern (19) and having mounted thereon a second electronic device (20) suitable for operation at said ambient temperature, said second substrate (18) being disposed outside the said heat insulating vacuum vessel means (2;2'); and connecting means (22) which pass through a wall of the said heat insulating vacuum vessel means (2;2') and electrically connect the circuit pattern (9) of the first substrate (8) to that of the second substrate (18);
characterised in that said first and second substrates (8;18) are attached to said heat insulating vacuum vessel means (2;2') so as to have respective main faces which are substantially co-planar, such that the separation between mutually-adjacent edges of the said first and second substrates (8;18) is minimized, and said connecting means (22) comprise a film cable formed, in such a way as to suppress heat transfer therealong, by alternately laminating a plurality of electrically-insulating films (22a,22c,22e) and a plurality of electrically-conductive films (22b,22d).

2. A package as claimed in claim 1, wherein the said first electronic device (10) comprises a superconducting device, the package further comprising cryogenic cooling means for maintaining the interior of said heat insulating vacuum vessel means (2;2') at an operating temperature of the superconducting device.

3. A package as claimed in claim 1 or 2, wherein said heat insulating vacuum vessel means (2) comprise an upper heat insulating vacuum portion (4) and a lower heat insulating vacuum portion (6) separate from the upper heat insulating vacuum portion (4), and wherein said film cable (22) is attached adhesively to a lower region of the upper heat insulating vacuum portion (4) and to an upper region of the lower heat insulating vacuum portion (6).

4. A package as claimed in claim 1 or 2, wherein said heat insulating vacuum vessel means (2') comprise a heat insulating vacuum vessel (50) provided with a slit (50a) in a side wall thereof, and a heat insulating vacuum lid (52) attached adhesively to the heat insulating vacuum vessel (50), and wherein said film cable (22) passes through the slit (50a) and is fastened adhesively to the heat insulating vacuum vessel (50).

5. A package as claimed in any preceding claim, wherein said first and second substrates (8,18) comprise multilayer ceramic substrates each formed by alternately laminating signal transmitting circuit patterns (9;19) and ground patterns (11;21).

## Patentansprüche

1. Ein Gehäuse für elektronische Vorrichtungen, umfassend: wärmeisolierende Vakuumgefäßmittel (2; 2'), die das Innere davon bei einer gewünschten Temperatur halten können, die niedriger als die Umgebungstemperatur außerhalb der wärmeisolierenden Vakuumgefäßmittel (2; 2') ist; ein erstes Substrat (8), das mit einem Schaltungsmuster (9) versehen ist und darauf angebracht eine erste elektronische Vorrichtung (10) aufweist, die für einen Betrieb bei der besagten gewünschten Temperatur geeignet ist, wobei das erste Substrat (8) innerhalb der wärmeisolierenden Vakuumgefäßmittel (2; 2') angeordnet ist; ein zweites Substrat (18), das mit einem Schaltungsmuster (19) versehen ist und darauf angebracht eine zweite elektronische Vorrichtung (20) aufweist, die für einen Betrieb bei der Umgebungstemperatur geeignet ist, wobei das zweite Substrat (18) außerhalb der wärmeisolierenden Vakuumgefäßmittel (2; 2') angeordnet ist; und Verbindungsmittel (22), welche durch eine Wand der besagten wärmeisolierenden Vakuumgefäßmittel (2; 2') durchgehen und das Schaltungsmuster (9) des ersten Substrats (8) mit dem des zweiten Substrats (18) elektrisch verbinden;
dadurch gekennzeichnet, daß die ersten und zweiten Substrate (8; 18) an die wärmeisolierenden Vakuumgefäßmittel (2; 2') angebracht sind, um so jeweilige Hauptflächen aufzuweisen, welche im wesentlichen koplanar sind, so daß die Trennung zwischen gegenseitig benachbarten Rändern der besagten ersten und zweiten Substrate (8; 18) minimiert ist, und die Verbindungsmittel (22) ein Filmkabel umfassen, das auf solch eine Weise gebildet wird, um eine Wärmeübertragung daran entlang zu unterdrücken, indem eine Vielzahl elektrisch isolierender Filme (22a, 22c, 22e) und eine Vielzahl elektrisch leitender Filme (22b, 22d) abwechselnd geschichtet werden.

2. Ein Gehäuse nach Anspuch 1, worin die besagte erste elektronische Vorrichtung (10) eine supraleitende Vorrichtung umfaßt, wobei das Gehäuse weiter umfaßt ein kryogenes Kühlmittel, um das Innere der wärmeisolierenden Vakuumgefäßmittel (2; 2') bei einer Betriebstemperatur der supraleitenden Vorrichtung zu halten.

3. Ein Gehäuse nach Anspruch 1 oder 2, worin die wärmeisolierenden Vakuumgefäßmittel (2) einen oberen wärmeisolierenden Vakuumteil (4) und einen unteren wärmeisolierenen Vakuumteil (6), getrennt von dem oberen wärmeisolierenden Vakuumteil (4), umfassen und worin das Filmkabel (22) klebend an einem unteren Bereich des oberen wärmeisolierenden Vakuumteils (4) und an einem oberen Bereich des unteren wärmeisolierenden Vakuumteils (6) angebracht ist.

4. Ein Gehäuse nach Anspruch 1 oder 2, worin die wärmeisolierenden Vakuumgefäßmittel (2') ein wärmeisolierendes Vakuumgefäß (50), das mit einem Schlitz (50a) in einer Seitenwand davon versehen ist, und einen wärmeisolierenden Vakuumdeckel (52) umfassen, der klebend an dem wärmeisolierenden Vakuumgefäß (50) angebracht ist, und worin das Filmkabel (22) durch den Schlitz (50a) durchgeht und klebend an dem wärmeisolierenden Vakuumgefäß (50) befestigt ist.

5. Ein Gehäuse nach irgendeinem vorhergehenden Anspruch, worin die ersten und zweiten Substrate (8, 18) Mehrschichten-Keramiksubstrate umfassen, die jeweils gebildet werden, indem signalübertragende Schaltungsmuster (9; 19) und Erdungsmuster (11; 21) abwechselnd geschichtet werden.

## Revendications

1. Boîtier pour dispositifs électroniques, comprenant : un moyen (2 ; 2') formant une enceinte sous vide thermiquement isolant, qui peut maintenir son intérieur à une température voulue inférieure à la température ambiante régnant à l'extérieur dudit moyen formant une enceinte sous vide thermiquement isolant (2, 2'); un premier substrat (8) qui est doté d'un motif de circuit (9) et sur lequel est monté un premier dispositif électronique (10) conçu pour fonctionner à ladite température voulue, ledit premier substrat (8) étant disposé à l'intérieur du moyen formant une enceinte sous vide thermiquement isolant (2, 2'); un deuxième substrat (18) qui est doté d'un motif de circuit (19) et sur lequel est monté un deuxième dispositif électronique (20) conçu pour fonctionner à ladite température ambiante, ledit deuxième substrat (18) étant disposé à l'extérieur dudit moyen formant une enceinte sous vide thermiquement isolant (2, 2'); et des moyens de connexion (22) qui traversent une paroi dudit moyen formant une enceinte sous vide thermiquement isolant (2;2') et qui connectent électriquement le motif de circuit (9) du premier substrat (8) à celui du deuxième substrat (18) ;
caractérisé en ce que lesdits premier et deuxième substrats (8 ; 18) sont fixés audit moyen formant une enceinte sous vide thermiquement isolant (2 ; 2') de façon que leurs faces principales respectives soient sensiblement coplanaires, de telle manière que la séparation entre les bords mutuellement adjacents desdits premier et deuxième substrats (8; 18) soit minimisée, et lesdits moyens de connexion (22) comprennent un câble du type film qui est formé, d'une manière permettant de supprimer le transfert de chaleur suivant sa longueur, par stratification alternée de plusieurs films électriquement isolants (22a, 22c, 22e) et de plusieurs films électriquement conducteurs (22b, 22d).

2. Boîtier selon la revendication 1, où ledit premier dispositif électronique (10) comprend un dispositif supraconducteur, le boîtier comprenant en outre un moyen de refroidissement cryogénique qui sert à maintenir l'intérieur dudit moyen formant une enceinte sous vide thermiquement isolant (2 ; 2') à la température de fonctionnement du dispositif supraconducteur.

3. Boîtier selon la revendication ou 2, où ledit moyen formant une enceinte sous vide thermiquement isolant (2) comprend une partie sous vide thermiquement isolante supérieure (4) et une partie sous vide thermiquement isolante inférieure (6) séparée de la partie sous vide thermiquement isolante supérieure (4), et où ledit câble du type film (22) est fixé par collage à une région inférieure de la partie sous vide thermiquement isolante supérieure (4) et à une région supérieure de la partie sous vide thermiquement isolante inférieure (6).

4. Boîtier selon la revendication 1 ou 2, où ledit moyen formant une enceinte sous vide thermiquement isolant (2') comprend une enceinte sous vide thermiquement isolante (50) dotée d'une fente (50a) ménagée dans une paroi latérale de celle-ci, et un couvercle sous vide thermiquement isolant (52) fixé par collage à l'enceinte sous vide thermiquement isolante (50), et où ledit câble du type film (22) passe dans la fente (50a) et est fixé par collage à l'enceinte sous vide thermiquement isolante (50).

5. Boîtier selon l'une quelconque des revendications précédentes, où lesdits premier et deuxième substrats (8, 18) comprennent des substrats céramiques multicouches qui sont chacun formés par stratification alternée de motifs de circuit de transmission de signaux (9 ;19) et de motifs de mise à la masse (11 ; 21).
